(19)

**Europäisches Patentamt**
**European Patent Office**
**Office européen des brevets**

(11) **EP 1 714 530 B1**

(12) **EUROPEAN PATENT SPECIFICATION**

(45) Date of publication and mention of the grant of the patent:
**14.05.2008 Bulletin 2008/20**

(51) Int Cl.:
***H05K 1/11*** (2006.01)

(21) Application number: **05702886.2**

(22) Date of filing: **03.02.2005**

(86) International application number:
**PCT/IB2005/050452**

(87) International publication number:
**WO 2005/076677 (18.08.2005 Gazette 2005/33)**

(54) **METHOD FOR INCREASING A ROUTING DENSITY FOR A CIRCUIT BOARD AND SUCH A CIRCUIT BOARD**

VERFAHREN ZUR VERGRÖSSERUNG EINER ROUTING-DICHTE FÜR EINE LEITERPLATTE UND EINE SOLCHE LEITERPLATTE

PROCEDE POUVANT AUGMENTER UNE DENSITE D'ACHEMINEMENT D'UNE CARTE DE CIRCUIT IMPRIME, ET CARTE DE CIRCUIT IMPRIME DE CE TYPE

(84) Designated Contracting States:
**AT BE BG CH CY CZ DE DK EE ES FI FR GB GR HU IE IS IT LI LT LU MC NL PL PT RO SE SI SK TR**

(30) Priority: **04.02.2004 US 541261 P**

(43) Date of publication of application:
**25.10.2006 Bulletin 2006/43**

(73) Proprietor: **NXP B.V.**
**5656 AG Eindhoven (NL)**

(72) Inventors:
• **ZHAO, Lily**
**San Jose, CA 95131-1706 (US)**

• **LOO, Michael**
**San Jose, CA 95131-1706 (US)**

(74) Representative: **Nollen, Maarten Dirk-Johan**
**Philips**
**Intellectual Property & Standards**
**Postbus 220**
**5600 AE Eindhoven (NL)**

(56) References cited:
**US-A- 5 784 262      US-A- 6 150 729**

## Description

The invention relates to the field of circuit boards and more specifically to the field of multi layer circuit boards.

There is a consumer demand for making electronic devices smaller. As a result, the semiconductor industry is integrating more functionality into integrated circuits, with these circuits also offering a decreased footprint. In recent years there has been an increasing push in electronic device manufacturing to utilize surface mount IC packages and components as opposed to the more traditional DIP packages. However, because the surface mount packages (SOIC) have tighter spaced pins, there is an increased difficulty in routing of signal traces and power traces to and from these packages, especially in between the pins thereof. Additionally, IC packages that mount to the surface of the circuit board utilizing ball grid arrays (BGAs) have become commonplace.

In order to facilitate surface mounting of BGAs and SOIC packages, multiple layer PCBs are employed in order to facilitate routing of signals and power between these packages. Typically, each PCB has upper and lower outer layers, upper and lower inner layer that are proximate the upper and lower outer layers, with core layers disposed between the upper and lower inner layers. These multiple layers are laminated in a substantially parallel relationship one to the other. Conducting traces are disposed on the layers in order to provide signal paths for connecting electrical components disposed on the surface of the PCB. Vias are formed by first drilling into the PCB and then by filling the drilled holes with conductive material in order to connect the various power and signal traces formed between the layers. For example, for a three layer PCB, vias between the second layer and the third layer are used to route signal traces and power traces to the ICs and other components disposed on the surface layers of the PCB.

Traditionally, signal traces for components disposed on the upper layer of the PCB are routed using the upper layer and inner layers that are as close as possible to the upper layer. This results in minimal drilling of vias into the core layers. The more vias that are drilled through the core layers, the higher the requirement for maintaining tighter tolerances. If tighter tolerances are not adhered to, then via clearance violations result on the core layers, which adversely affects the costs of the PCB.

United States Patent No. 6,150,729, entitled "Routing density enhancement for semiconductor BGA packages and printed wiring boards," discloses a routing scheme for a multilayer printed wiring board or semiconductor package is disclosed. Each of a first group of electrical contacts, such as bond pads, is disposed on a first surface and is electrically coupled to one of a plurality of conductive surface connectors such as vias. Each of a second group of electrical contacts is disposed on the first surface and is routed by one of a second plurality of traces. The orientation between certain electrical contacts in the first group and their associated vias is different than the orientation between certain other electrical contacts in the first group and their associated vias. This varying orientation allows greater routing density on the second surface. Unfortunately, because of the tolerances required between vias and conducting traces on the inner and core layers, this type of printed wiring board does not facilitate low manufacturing cost.

A need therefore exists to provide a multilayer printed circuit board (MPCB) that is manufacturable in a cost effective manner.

The invention provides a multilayer printed circuit board that overcomes the deficiencies of the prior art.

In accordance with the invention there is provided a multilayer circuit board comprising: a first layer; a fourth layer substantially parallel to the first layer; a plurality of electrical contacts formed on the first layer of the multilayer circuit board and disposed in a first grid having, a first subset of the plurality of electrical contacts for routing within the first layer, and a second subset of the plurality of electrical contacts for routing within the fourth layer; and, a plurality of vias formed between the first and fourth layers and each disposed adjacent at least one of the second subset of the plurality of electrical contacts, the plurality of vias having a spacing between each pair thereof larger than a smallest spacing between adjacent electrical contacts of the plurality of electrical contacts.

In accordance with the invention there is provided a method of manufacturing a multilayer circuit board comprising: providing a first layer; providing a fourth layer substantially parallel to the first layer; disposing a plurality of electrical contacts in a first grid within the first layer, the plurality of electrical contacts arranged in a first subset and a second subset; routing the first subset of electrical contacts within the first layer; forming vias between the first and fourth layers, each via adjacent at least one of the second subset of the plurality of electrical contacts and each via spaced from other vias by at least 1.2 times a minimum spacing between electrical contacts of the first and second subsets; and, routing the second subset of the plurality of electrical contacts within the fourth layer.

Exemplary embodiments of the invention will now be described in conjunction with the following drawings, in which:

FIGs. 1a, 1b, 1c and 1d illustrates a prior art multilayer printed circuit board (MPCB) that is formed from a first layer, a second layer, a third layer and a fourth layer;

FIGs. 2a, 2b, 2c and 2d illustrate a MPCB that is routed using a routing strategy in accordance with a first embodiment of the invention;

FIGs. 3a, 3c and 3d illustrate a MPCB that has eight and ten layers that is routed using the routing strategy in accordance with the first embodiment of the invention; and,

FIG. 3b illustrates an eight layer MPCB for being routed using the routing concept in accordance with the first embodiment of the invention.

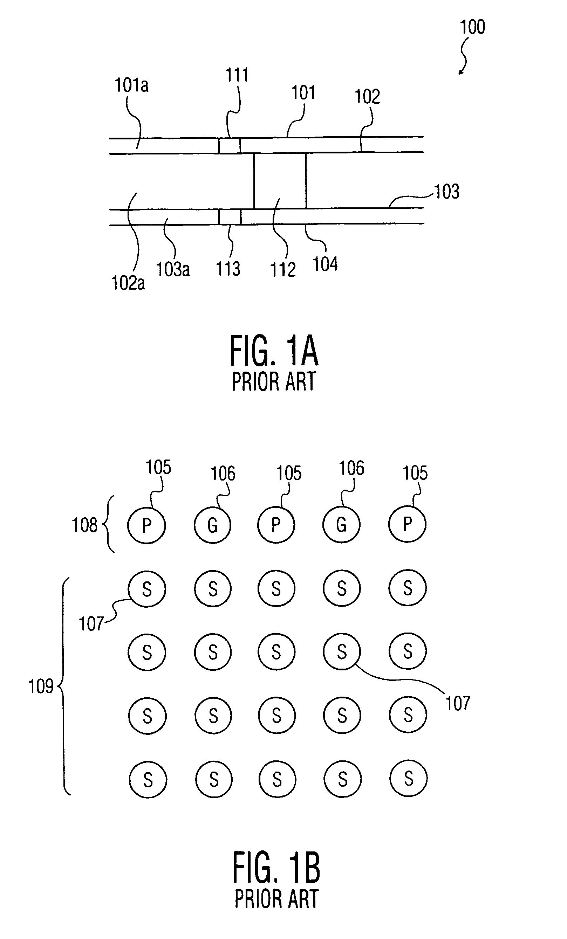

FIG. 1a illustrates a prior art multilayer printed circuit board (MPCB) 100 that is formed from a first layer 101, a second layer 102, invention that implements a variation of the routing concept in accordance a third layer 103 and a fourth layer 104. The first layer is formed on an upper surface of a first substrate 101a. The second and third layers, 102 and 103, are formed on opposite sides of a second substrate 102a. The fourth layer 104 is formed on a bottom surface of the third substrate 103a.

In accordance with the prior art example illustrated in FIG. 1b, one row 108 of alternating power 105 and ground 106 electrical contacts and four rows 109 of electrical contacts 107 are to be routed for the four-layer MPCB 100. Referring to FIG. 1a, the conducting traces associated with the electrical contacts 107 are disposed within the first and fourth layers, 101 and 104, of the MPCB 100. Conducting traces associated with the power and ground signals are disposed within the second and third layers, 102 and 103.

Referring back to FIG. 1a, conducting vias, 111, 112 and 113, are formed within the MPCB 100 in order to route the power and ground signals from the core layers 102 and 103 to the surface layers, comprised of the first layer 101 and the fourth layer 104. A first conducting via 111 is used to route electrical signals between the first layer 101 and the second layer 102, a second conducting via 112 is used to route electrical signals between the second layer 102 and the third layer 103. A third conducting via 113 is used to route electrical signals between the third layer 113 and the fourth layer 114. For example, in order to route power and ground signals to the first layer 101, the second conducting via 112 routes the power signal from the third layer 113 to the second layer 112 and the first conducting via routes the power signal from the second layer 112 to the first layer 111. Similarly, the third conducting via 113 is used to route the electrical signal between the fourth layer 114 and the first layer using the first and second conducting vias. Thus, a plurality of the first through third conducting vias, 111 to 113, in conjunction with a plurality of conducting traces disposed on the first through fourth layers, 101 through 104, serve to route a plurality of electrical signals between any of the first through fourth layers, 101 through 104. Alternatively, a conducting via is formed from the first layer 111 to the fourth layer 114 for routing of a signal from the first layer 111 to the fourth layer 114. Of course, forming of conducting vias is dependent upon routing requirements for the MPCB 100, thus the conducting vias are formed as required in order to facilitate the routing.

The orientation of the ground, power and signal electrical contacts, as illustrated in FIG. 1b, is common in package substrate routing or PCB routing, such as for use with ball grid arrays (BGAs), known to those of skill in the art. The five rows illustrated, 108 and 109, in FIG. 1b are exemplary of either flip chip bumps or BGA ball pads. As is known to those of skill in the art, laminating the MPCB 100 by alternating signal layers and power or ground layers reduces bi-planar cross-talk. Thus, power and ground layers typically separate signal layers.

In order to reduce assembly tolerances when manufacturing of the MPCB 100, larger diameter non-conducting areas are typically utilized on core layers, for example the second and third layers, 102 and 103, in order to offset tolerances needed in laminating the MPCB 100 and for forming of the conducting vias. Therefore MPCB design rules for inner layer via diameter and pitch require higher manufacturing tolerances than for the outer layers.

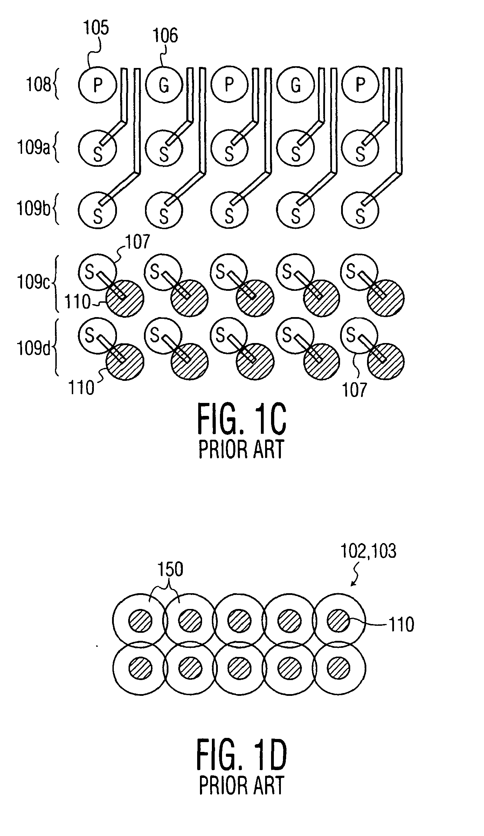

Referring to prior art FIG. 1c, the first two rows of signal pads, 109a and 109b, are routed from their respective signal pad along the first layer 101. The third and fourth rows of signal pads, 109c and 109d, are routed using conducting vias that are drilled down through the first through third substrates, 101 a through 103a, to the fourth layer 104. Within this fourth layer, the electrical signals from the signal pads forming the third and fourth rows 109c and 109d are routed out of the MPCB 100. Unfortunately because non-conducting areas formed on the inner layers require bigger diameter and larger pitch therebetween, clearance violations on the core layer are typically observed. Normally in order to solve the problem of clearance violations, additional routing layers are utilized or tighter design rules are implemented. Unfortunately, this results in a requirement to increase laminating tolerances of the MPCB 100 and thus increases the manufacturing cost of the MPCB 100.

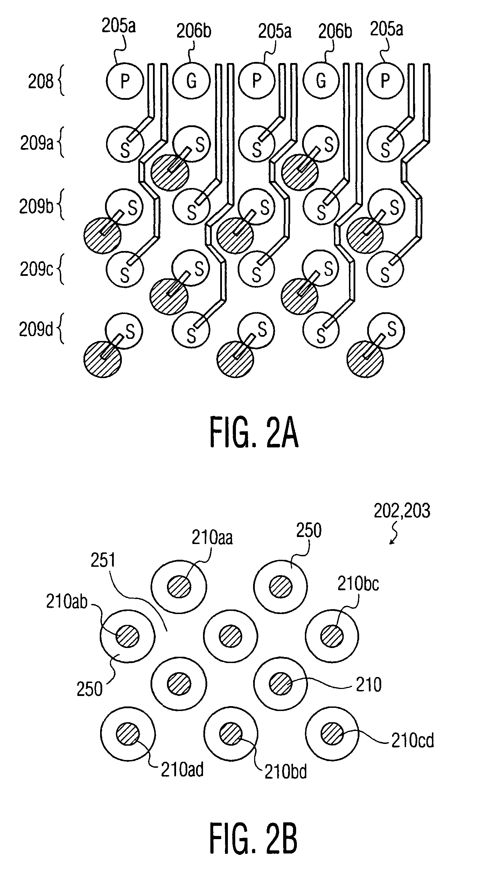

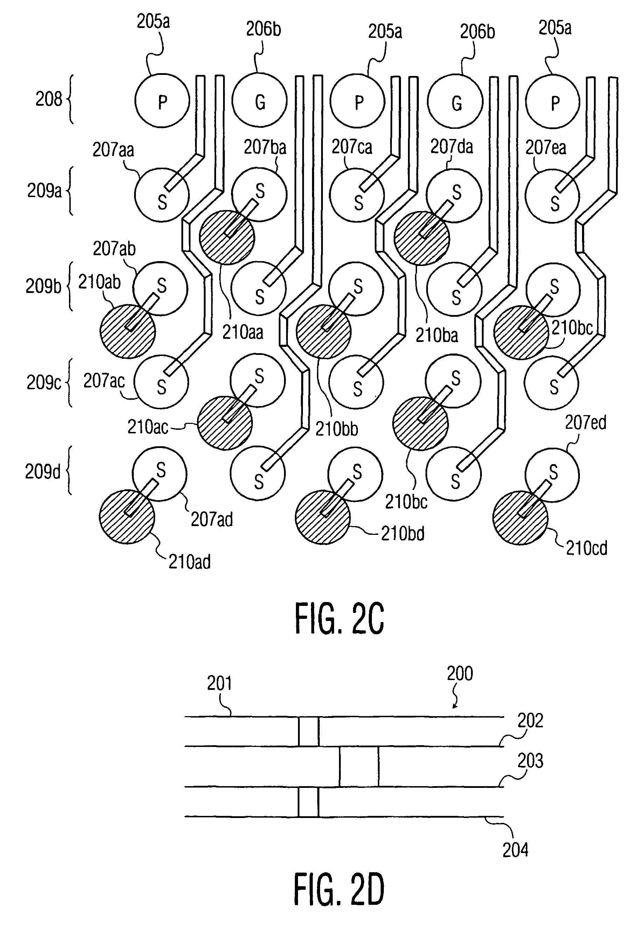

FIGs. 2a, 2b, 2c and 2d illustrate routing for a multilayer printed circuit board (MPCB) 200 in accordance with a first embodiment of the invention. For the purposes of this embodiment, the MPCB 200 is formed from four layers, 201 through 204. Of course, multi layer boards having any number of layers from two layers to ten layers, or more, are also envisaged. The MPCB 200 comprises a first layer 201 and a fourth layer 204 substantially parallel to the first layer 201, with second and third core layers, 202 and 203.

Similarly, in contrast to the MPCB illustrated in prior art FIG. 1c, FIG. 2a illustrates a plurality of electrical contacts formed within the first layer 201 of the multilayer circuit board and arranged in a first grid according to the invention. A first row 208 of alternating power electrical contacts 205a, 205b and 205c and ground pads 206a and 206b. In addition, first through fourth rows of signal electrical contacts, 209a through 209d, are disposed within the first layer 201 of the MPCB 200. The signal electrical contacts are divided into two sets. A first subset of the plurality of electrical contacts is for routing within the first layer 201, and a second subset of the plurality of electrical contacts is for routing within the fourth layer 204. Of course, the layer within which the second subset is routed is dependent upon a number of layers that form the MPCB 200 and is not limited to the fourth layer 204. Because a four layer MPCB 200 is shown in the example, and because it is preferable not to dispose two signal layers adjacent each other, the fourth layer 204 is used for signal routing. However, if an eight layer MPCB is utilized for routing, then preferably any other non-adjacent layer is utilized for routing of the second subset.

Referring to FIG. 2c, electrical contacts 207aa, 207ca, 207ea, 207bb, 207db, 207ac, 207cc, 207ec, 207bd, and 207dd belong to the first subset and electrical contacts 207ba, 207da, 207ab, 207cb, 207eb, 207bc, 207dc, 207ad, 207cd and 207ed belong to the second subset.

A plurality of vias, 210aa, 210ba, 210ab, 210bb, 210bc, 210ac, 210bc, 210ad, 210bd and 210cd are formed between the first and fourth layers, 201 and 204, and each via from the plurality is disposed adjacent at least one of the second subset of the plurality of electrical contacts, where the plurality of vias have a spacing therebetween that is larger than a spacing between each of the plurality of electrical contacts.

With reference to the plurality of electrical contacts disposed in a first grid, in the form of a Cartesian grid, which is an array formed from columns and orthogonal rows, , as shown in FIG. 2a and FIG. 2c, the routing strategy in accordance with the first embodiment of the invention reduces the tolerance problem by routing and drilling, to form vias, for alternate electrical contacts in a single signal row and for alternate electrical contacts in a single column, for all four rows. The electrical contacts are preferably disposed an intersections of the columns and orthogonal rows of the Cartesian grid. FIG. 2c illustrates an enlarged view of FIG. 2a in order to exemplify the properties of the invention. For the first row of electrical contacts 209a, electrical contacts 207aa, 207ca and 207ea are routed along the first layer using conducting traces. Electrical contacts 207ba and 207da are connected with electrically conducting traces formed on the first layer to vias 210aa and 210ba, respectively, for routing along the fourth layer 204. For the second row of electrical contacts 209b, electrical contacts 207ab, 207cb and 207eb are coupled using electrically conducting traces formed within the first layer 201 to vias 210ab and 210bb, respectively, for routing within the fourth layer 204. Electrical contacts 207bb and 207db are routed within the first layer using conducting traces. For the third row of electrical contacts 209c, electrical contacts 207ac, 207cc and 207ec are routed within the first layer using conducting traces. Electrical contacts 207bc and 207dc are connected with electrically conducting traces formed within the first layer to vias 210ac and 210bc, respectively, for routing within the fourth layer 204. For the fourth row of electrical contacts 209d, electrical contacts 207ad, 207cd and 207ed are connected with electrically conducting traces formed on the first layer to vias 210ad, 210bd and 210cd, respectively, for routing within the fourth layer 204. Electrical contacts 207bd and 207dd are routed within the first layer using conducting traces.

Referring to prior art FIG. 1d, a ground or power layer of the MPCB 100 is shown. In order to facilitate decreased MPCB assembly costs, large non-conducting areas 150 are formed on the ground of power layer to facilitate forming of vias therein. Because of the pitch of the electrical contacts forming the third and fourth rows 109c and 109d, the resulting non-conducting areas that are formed on the ground of power layer overlap. In this case, the pitch of the vias is equal to, or less than, the diameter of a single via. This overlap between the non-conducting areas does not facilitate a continuously conducting surface and thus a continuous ground or power plane cannot be formed

Of course, if tighter tolerances are adhered to in the laminating and drilling of the MPCB 100, then such an overlap between non-conducting areas of the power and ground layers likely does not occur, however the manufacturing costs are significantly increased. Referring to FIG. 2b, the non-conducting areas 250 are illustrated for the ground and power layers, 202 and 203, of the MPCB 200. The non-conducting areas 250 are surrounded by electrically conducting material 251 that forms the ground and power layers, 202 and 203. Where within these non-conducting areas 250, the vias used for routing of the second subset of electrical contacts, 207ba, 207da, 207ab, 207cb, 207eb, 207bc, 207dc, 207ad, 207cd and 207ed, from the first layer 201 to the fourth layer 204, are formed and are arranged in a second grid. The second grid is at an angle to the first grid in a diagonal orientation with respect to the first grid. A pitch of the vias arranged in the second grid is preferably $\sqrt{2}$ times the pitch of the electrical contacts arranged in the first grid. Thus, the first embodiment of the invention provides for avoidance of via clearance violations with bottom signal layer, fourth signal layer, being utilized for routing. Because the non-conducting areas are spaced at $\sqrt{2}$ times the pitch of the electrical contacts, continuous electrical connection around the non-conducting areas is facilitated and as such the ground or power layer within which these non-conducting areas are formed facilitates acting as a layer for decreasing bi-planar cross-talk between adjacent signal layers.

Preferably, the first grid is such that the orientation of the ground, 206a and 206b, power, 205a through 205c, and signal electrical contacts belonging to the first and second subsets, is for being interfaced with BGA packages or with flip chip bumps. Further preferably, the MPCB 200 in accordance with the embodiments of the invention is formed by laminating alternating signal layers and power or ground layers in order to reduce bi-planar cross-talk.

The routing concept in accordance with the first embodiment of the invention is applicable to more complicated routing scenarios where a larger plurality of electrical contacts are routed, for example, in eight-layer or even ten-layer circuit boards.

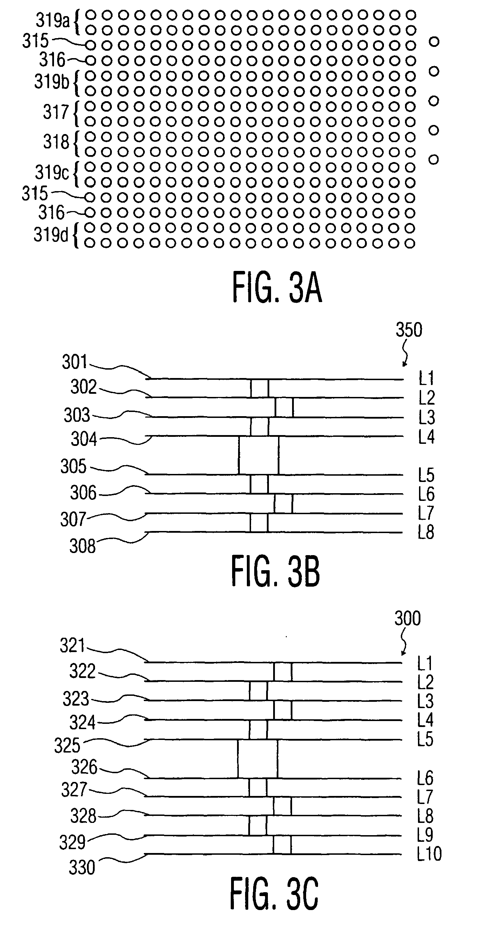

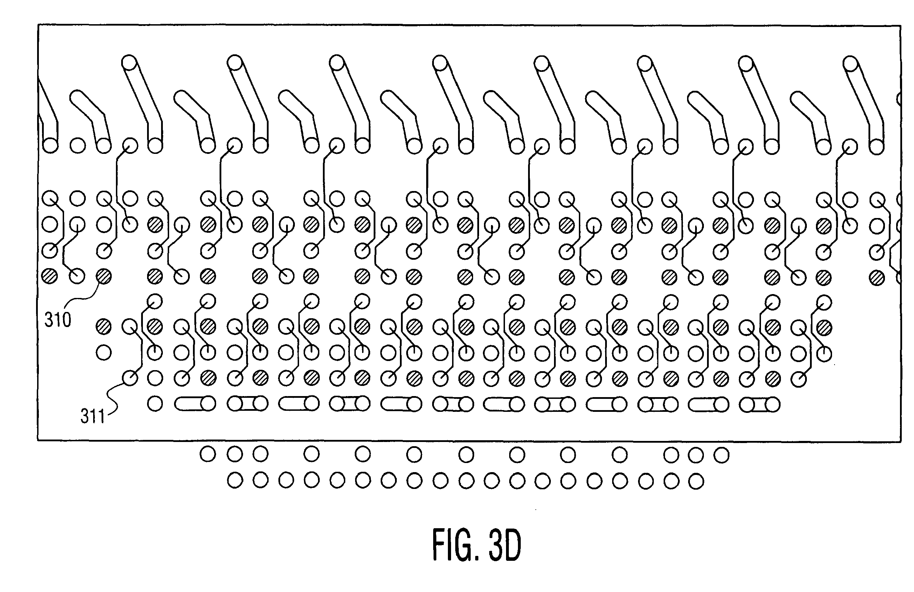

FIGs. 3a, 3c and 3d illustrate a MPCB 300 that utilizes the routing strategy in accordance with the first embodiment of the invention. FIG. 3a illustrates an exemplary arrangement of electrical contacts on a single layer of a MPCB 300. For example, for the ten layer cross section of the MPCB 300 as shown in FIG. 3c, the first layer (L1) 321 is an electrical power layer and is routed to electrical pads 315. The second layer L2 302 is a signal layer, which is routed to electrical contacts 319a. A third layer 323 is a ground layer, which is routed to electrical contacts 316. A fourth layer 324 is a signal layer that is routed to electrical contacts 319b. Fifth and sixth layers, 325 and 326, are core power and core ground layers, these layers are routed to electrical contacts 318 and 317, respectively. A seventh layer 327 is a signal layer, which is routed to electrical contacts 319c. Eight and tenth layers, 328 and 330 are power and ground layers, which are routed to electrical contacts 315 and 316, respectively. A ninth layer 329 is a signal layer, which is routed to electrical contacts 319d.

FIG. 3b illustrates an eight layer MPCB 350 and FIG. 3c illustrates a ten layer MPCB 300. Referring to FIGs 3b and 3c, because the core of the MPCB, 350 and 300, formed from layers 325 and 326, and 304 and 305, a larger via and pitch is required than for the surface layers 301 and 308 and 321 and 330. Referring back to prior art FIGs. 1 a through 1d, because of the larger non-conducting area requirements for the core layers, typically 90% of routing for the signal layers is performed on the outer layers of a MPCB 100. Unfortunately, bottom signal layers, 104, are mostly empty and not utilized for routing. Instead a majority of the routing is performed on the upper layers, 101, typically on first through fourth layers, in order to avoid utilizing vias that cross the core layers, 102 and 103. However, in order to achieve high trace densities on upper signal layers 101, manufacturability issues typically result in a high manufacturing cost for these MPCBs. In some cases, if signal routing is not possible within dedicated signal layers, power and ground layers are partially utilized for signal routing, which results in poor electrical performance of the MPCB 100. There is a known trade off between performance and cost for routing density.

Referring to FIG. 3d, the routing scheme in accordance with the first embodiment of the invention is utilized for one of the signal layers as shown. Non conducting areas and vias formed therein, denoted by 310, are arranged in zigzag pattern for this second layer 322, either a ground or power layer, so that the vias are able pass through the core layers, 325 and 326, of the MPCB. Thus, on the third layer 323, more signals are routed because the vias 310 are at diagonal positions and thus provide more space for routing therebetween. As a result, the rest of the signals are routed to the bottom signal layers. On core layers, vias 310 are able to pass through without violating clearance rules because their pitch is at least $\sqrt{2}$ times the pitch of electrical contacts 311. In this manner, both the upper and lower signal layers, 322 and 329, are used for routing with approximately balanced routing densities on each. This provides for an MPCB 300 having routing that offers performance and is realized in a cost efficient manner.

The routing strategy established in accordance with the first embodiment of this invention allows for routing by drilling vias diagonally. It thus provides increased room between vias, than was attainable in the prior art, but also vias are drilled on core layers in a zigzag pattern, attaining via pitch that is $\sqrt{2}$ times the pitch of the electrical contacts. This allows for avoiding of via clearance violations and allows for bottom signal layer to be utilized for efficient signal or power routing. Furthermore, the ground and power layers that have the non-conducting areas formed thereon act for reducing bi-planar crosstalk between adjacent signal layers because a conductive material for conducting of power or ground surrounds a plurality of the non-conducting areas.

Numerous other embodiments may be envisaged without departing from the scope of the invention.

**Claims**

1. A multilayer circuit board comprising:a first layer (201); a fourth layer (204) substantially parallel to the first layer (201); a plurality of electrical contacts (207aa, 207ca, 207ea, 207bb, 207db, 207ac, 207cc, 207ec, 207bd, 207dd, 207ba, 207da, 207ab, 207cb, 207eb, 207bc, 207dc, 207ad, 207cd, 207ed; 311) formed within the first layer (201) of the multilayer circuit board and disposed in a first grid having, a first subset (207aa, 207ca, 207ea, 207bb, 207db, 207ac, 207cc, 207ec, 207bd, 207dd) of the plurality of electrical contacts for routing within the first layer (201), and a second subset (207ba, 207da, 207ab, 207cb, 207eb, 207bc, 207dc, 207ad, 207cd, 207ed) of the plurality of electrical contacts for routing within the fourth layer (204); and, a plurality of vias (210aa, 210ba, 210ab, 210bb, 210bc, 210ac, 210bc, 210ad, 210bd, 210cd; 310) formed between the first layer (201) and fourth layer (204) and each disposed adjacent at least one of the second subset (207ba, 207da, 207ab, 207cb, 207eb, 207bc, 207dc, 207ad, 207cd, 207ed) of the plurality of electrical contacts, the plurality of vias (210aa, 2106a, 210ab, 210bb, 210bc, 210ac, 210bc, 210ad, 210bd and 210cd; 310) having a spacing between each pair thereof larger than a smallest spacing between adjacent electrical contacts of the plurality of electrical contacts (207aa, 207ca, 207ea, 207bb, 207db, 207ac, 207cc, 207ec, 207bd, 207dd, 207ba, 207da, 207ab, 207cb, 207eb, 207bc, 207dc, 207ad, 207cd, 207ed; 311).

2. A multilayer circuit board according to claim 11, wherein the plurality of vias (210aa, 210ba, 210ab, 210bb, 210bc, 210ac, 210bc, 210ad, 210bd, 210cd; 310) have a spacing of at least 1.1 times the first grid spacing.

3. A multilayer circuit board according to claim 2, wherein electrical contacts of the plurality of electrical contacts within the first grid alternate between the first subset of electrical contacts (207aa, 207ca, 207ea, 207bb, 207db, 207ac, 207cc, 207ec, 207bd, 207dd) and the second subset of electrical contacts (207ba, 207da, 207ab, 207cb, 207eb, 207bc, 207dc, 207ad, 207cd, 207ed).

4. A multilayer circuit board according to claim 1, wherein the first grid comprises a Cartesian grid comprising columns and rows, where each row and each column comprises alternating electrical contacts from the first subset (207aa, 207ca, 207ea, 207bb, 207db, 207ac, 207cc, 207ec, 207bd, 207dd) and the second subset (207ba, 207da, 207ab, 207cb, 207eb, 207bc, 207dc, 207ad, 207cd, 207ed), the plurality of vias (210aa, 210ba, 210ab, 210bb, 210bc, 210ac, 210bc, 210ad, 210bd, 210cd; 310) disposed in a second grid comprising columns and rows having a substantially second pitch between adjacent vias, where electrical contacts for the first subset (207aa, 207ca, 207ea, 207bb, 207db, 207ac, 207cc, 207ec, 207bd, 207dd) are routed within the first layer (201) using one of a plurality of first electrical traces and electrical contacts for the second subset (207ba, 207da, 207ab, 207cb, 207eb, 207bc, 207dc, 207ad, 207cd, 207ed) are routed along the fourth layer (204) using one of a plurality of second electrical traces.

5. A multilayer circuit board according to claim 4, wherein pitch of the vias (210aa, 210ba, 210ab, 210bb, 210bc, 210ac, 210bc, 210ad, 210bd and 210cd, 310) disposed in a second grid is at least 1.1 times larger than the pitch of the electrical contacts disposed in the first grid.

6. A multilayer circuit board according to claim 5, wherein pitch of the vias (210aa, 210ba, 210ab, 210bb, 210bc, 210ac, 210bc, 210ad, 210bd, 210cd; 310) disposed in a second grid is approximately the square root of two times larger than the pitch of the plurality of electrical contacts disposed in the first grid.

7. A multilayer circuit board according to claim 4, wherein the angle between the first grid and the second grid is approximately 45 degrees.

8. A multilayer circuit board according to claim 1, wherein the first subset (207aa, 207ca, 207ea, 207bb, 207db, 207ac, 207cc, 207ec, 207bd, 207dd) of the plurality of electrical contacts comprise bond pads.

9. A multilayer circuit board according to claim 1, wherein the vias (210aa, 210ba, 210ab, 210bb, 210bc, 210ac, 2106c, 210ad, 210bd, 210cd; 310) are disposed at opposite sides of adjacent electrical contacts belonging to the second subset (207ba, 207da, 207ab,207cb,207eb,207bc,207dc,207ad, 207cd,207ed).

10. A multilayer circuit board according to claim 1, comprising a first substrate, where the first layer (201) is disposed within a first outside surface of the first substrate and where the plurality of vias (210aa, 210ba, 210ab, 210bb, 210bc, 210ac, 210bc, 210ad, 210bd and 210cd; 310) are drilled through the first substrate to a second other outside surface thereof, where the fourth layer (204) is disposed within the second other outside surface of the first substrate.

11. A multilayer circuit board according to claim 1, comprising a core layer disposed between the first and fourth layers, wherein the core layer comprises a plurality of other layers (202, 203) that are substantially parallel to the first layer (201) and the fourth layer (203) and the plurality of other layers (202, 203) comprising a plurality of non-conducting areas (250) that surround the plurality of vias (210aa, 210ba, 210ab, 210bb, 210bc, 210ac, 210bc, 210ad, 210bd, 210cd; 310).

12. A multilayer circuit board according to claim 11, comprising an electrically conducting material (251) disposed about the plurality of non-conducting areas (250) for reducing a bi-planar cross-talk between the first layer (201) and the fourth layer (204).

13. A multilayer circuit board according to claim 12, wherein the plurality of non-conducting areas (250) are disposed in such a manner that vias formed on adjacent electrical contacts from the plurality of electrical contacts (207aa, 207ca, 207ea, 207bb, 207db, 207ac, 207cc, 207ec, 207bd, 207dd, 207ba, 207da, 207ab, 207cb, 207eb, 207bc, 207dc, 207ad, 207cd, 207ed) are other than supported due to overlap between adjacent non-conducting areas (250).

14. A multilayer circuit board according to claim 13, wherein each of the plurality of non-conducting areas (250) is free of all other electrical contact other than a via (210aa, 210ba, 210ab, 210bb, 210bc, 210ac, 210bc, 210ad, 210bd, 210cd; 310) disposed therein once the multilayer circuit board is formed.

15. A multilayer circuit board according to claim 1, wherein each via (210aa, 210ba, 210ab, 210bb, 210bc, 210ac, 210bc, 210ad, 210bd, 210cd; 310) is adjacent at least two electrical contacts.

**16.** A method of manufacturing a multilayer circuit board comprising: providing a first layer (201); providing a fourth layer (204) substantially parallel to the first layer (201); disposing a plurality of electrical contacts (207aa, 207ca, 207ea, 207bb, 207db, 207ac, 207cc, 207ec, 207bd, 207dd, 207ba, 207da, 207ab, 207cb, 207eb, 207bc, 207dc, 207ad, 207cd, 207ed; 311) in a first grid within the first layer, the plurality of electrical contacts arranged in a first subset (207aa, 207ca, 207ea, 207bb, 207db, 207ac, 207cc, 207ec, 207bd, 207dd) and a second subset (207ba, 207da, 207ab, 207cb, 207eb, 207bc, 207dc, 207ad, 207cd, 207ed); routing the first subset (207aa, 207ca, 207ea, 207bb, 207db, 207ac, 207cc, 207ec, 207bd, 207dd) of electrical contacts within the first layer (201); forming vias (210aa, 210ba, 210ab, 210bb, 210bc, 210ac, 210bc, 210ad, 210bd, 210cd; 310) between the first layer (201) and fourth layer (204), each via adjacent at least one of the second subset (207ba, 207da, 207ab, 207cb, 207eb, 207bc, 207dc, 207ad, 207cd, 207ed) of the plurality of electrical contacts and each via spaced from other vias by at least 1.2 times a minimum spacing between electrical contacts of the first subset (207aa, 207ca, 207ea, 207bb, 207db, 207ac, 207cc, 207ec, 207bd, 207dd) and the second subset (207ba, 207da, 207ab, 207cb, 207eb, 207bc, 207dc, 207ad, 207cd, 207ed); and, routing the second subset (207ba, 207da, 207ab, 207cb, 207eb, 207bc, 207dc, 207ad, 207cd, 207ed) of the plurality of electrical contacts within the fourth layer (204).

**17.** A method according to claim 16, wherein the pitch between adjacent vias is approximately a square root of two times the pitch of the plurality of electrical contacts (207aa, 207ca, 207ea, 207bb, 207db, 207ac, 207cc, 207ec, 207bd, 207dd, 207ba, 207da, 207ab, 207cb, 207eb, 207bc, 207dc, 207ad, 207cd, 207ed; 311).

**18.** A method according to claim 16, comprising: providing a first plurality of electrical traces disposed within the first layer (201) for routing of the first subset (207aa, 207ca, 207ea, 207bb, 207db, 207ac, 207cc, 207ec, 207bd, 207dd) of electrical contacts; and providing a second plurality of electrical traces disposed within the fourth layer for routing of the second subset (207ba, 207da, 207ab, 207cb, 207eb, 207bc, 207dc, 207ad, 207cd, 207ed) of electrical contacts, wherein a number of elements within the second plurality is within 50% of a number of elements of the first plurality.

**19.** A method according to claim 18, wherein a number of elements within the second plurality is within 10% of a number of elements of the first plurality.

**20.** A method according to claim 16, wherein the angle is approximately 45 degrees.

**21.** A method according to claim 16, comprising providing a core layer between the first layer (201) and the fourth layer (204), wherein the core layer comprises a plurality of other layers (202, 203) that are substantially parallel to the first layer (201) and the fourth payer (204), the plurality of other layers (202, 203) comprising a plurality of non-conducting areas (250) that surround the plurality of vias (210aa, 210ba, 210ab, 210bb, 210bc, 210ac, 210bc, 210 ad, 2106d, 210cd; 310).

**22.** A method according to claim 21, comprising providing an electrically conducting material (251) disposed about the plurality of non-conducting areas (250) for reducing a bi-planar cross-talk between the first layer (201) and the fourth layer (204).

**23.** A method according to claim 21, wherein the plurality of non-conducting areas (250) are disposed in such a manner that vias (210aa, 210ba, 210ab, 210bb, 210bc, 210ac, 210bc, 210ad, 210bd, 210cd; 310) formed on adjacent electrical contacts from the plurality of electrical contacts are other than supported due to an overlap between adjacent non-conducting areas.

**24.** A method according to claim 23, wherein each of the plurality of non-conducting areas (250) is free of all other electrical contact other than a via (210aa, 210ba, 210ab, 210bb, 210bc, 210ac, 210bc, 210ad, 210bd, 210cd; 310) disposed therein once the multilayer circuit board is formed.

**Patentansprüche**

**1.** Mehrlagenleiterplatte, umfassend: eine erste Lage (201); eine vierte Lage (204), im Wesentlichen parallel zu der ersten Lage (201); mehrere elektrische Kontakte (207aa, 207ca, 207ea, 207bb, 207db, 207ac, 207cc, 207ec, 207bd, 207dd, 207ba, 207da, 207ab, 207cb, 207eb, 207bc, 207dc, 207ad, 207cd, 207ed; 311), ausgebildet innerhalb der ersten Lage (201) der Mehrlagenleiterplatte und angeordnet in einem ersten Raster, welches eine erste Untergruppe (207aa, 207ca, 207ea, 207bb, 207db, 207ac, 207cc, 207ec, 207bd, 207dd) der mehreren elektrischen Kontakte zum Routen innerhalb der ersten Lage (201) aufweist, und eine zweite Untergruppe (207ba, 207da, 207ab, 207cb, 207eb, 207bc, 207dc, 207ad, 207cd, 207ed) der mehreren elektrischen Kontakte zum Routen innerhalb der vierten Lage (204); und mehrere Durchkontaktierungen (210aa, 210ba, 210ab, 210bb, 210bc, 210ac, 210bc, 210ad, 210bd, 210cd; 310), ausgebildet zwischen der ersten Lage (201) und der vierten Lage (204) und je angeordnet benachbart wenigstens einem der zweiten Untergruppe (207ba, 207da, 207ab, 207cb, 207eb, 207bc, 207dc, 207ad, 207cd, 207ed) der mehreren elektrischen Kontakte, wobei die mehreren Durchkontaktierungen (210aa, 210ba, 210ab, 210bb, 210bc, 210ac, 210bc, 210ad, 210bd und 210cd; 310) eine Beabstandung zwischen jedem Paar derselben aufweisen, größer als eine kleinste Beabstandung zwischen benachbarten elektrischen Kontakten der mehreren elektrischen Kontakte (207aa, 207ca, 207ea, 207bb, 207db, 207ac, 207cc, 207ec, 207bd, 207dd, 207ba, 207da,207ab,207cb, 207eb,207bc,207dc,207ad,207cd,207ed;311).

2. Mehrlagenleiterplatte nach Anspruch 1, wobei die mehreren Durchkontaktierungen (210aa, 210ba, 210ab, 210bb, 210bc, 210ac, 210bc, 210ad, 210bd, 210cd; 310) eine Beabstandung von wenigstens 1,1 mal der ersten Rasterbeabstandung aufweisen.

3. Mehrlagenleiterplatte nach Anspruch 2, wobei elektrische Kontakte der mehreren elektrischen Kontakte innerhalb des ersten Rasters zwischen der ersten Untergruppe elektrischer Kontakte (207aa, 207ca, 207ea, 207bb, 207db, 207ac, 207cc, 207ec, 207bd, 207dd) und der zweiten Untergruppe elektrischer Kontakte (207ba, 207da, 207ab, 207cb, 207eb, 207bc, 207dc, 207ad, 207cd, 207ed) alternieren.

4. Mehrlagenleiterplatte nach Anspruch 1, wobei das erste Raster ein kartesisches Raster umfasst, umfassend Spalten und Reihen, wobei jede Reihe und jede Spalte alternierende elektrische Kontakte aus der ersten Untergruppe (207aa, 207ca, 207ea, 207bb, 207db, 207ac, 207cc, 207ec, 207bd, 207dd) und der zweiten Untergruppe (207ba, 207da, 207ab, 207cb, 207eb, 207bc, 207dc, 207ad, 207cd, 207ed) umfasst, wobei die mehreren Durchkontaktierungen (210aa, 210ba, 210ab, 210bb, 210bc, 210ac, 210bc, 210ad, 210bd, 210cd; 310), in einem zweiten Raster angeordnet sind, welches Spalten und Reihen umfasst, welche einen im Wesentlichen zweiten Abstand zwischen benachbarten Durchkontaktierungen aufweisen, wobei elektrische Kontakte für die erste Untergruppe (207aa, 207ca, 207ea, 207bb, 207db, 207ac, 207cc, 207ec, 207bd, 207dd) innerhalb der ersten Lage (201) geroutet sind, unter Verwendung einer von mehreren ersten elektrischen Bahnen, und elektrische Kontakte für die zweite Untergruppe (207ba, 207da, 207ab, 207cb, 207eb, 207bc, 207dc, 207ad, 207cd, 207ed) entlang der vierten Lage (204) geroutet sind, unter Verwendung einer von mehreren zweiten elektrischen Bahnen.

5. Mehrlagenleiterplatte nach Anspruch 4, wobei Abstand der Durchkontaktierungen (210aa, 210ba, 210ab, 210bb, 210bc, 210ac, 210bc, 210ad, 210bd und 210cd; 310), welche in einem zweiten Raster angeordnet sind, wenigstens 1,1 mal größer ist als der Abstand der elektrischen Kontakte, welche in dem ersten Raster angeordnet sind.

6. Mehrlagenleiterplatte nach Anspruch 5, wobei Abstand der Durchkontaktierungen (210aa, 210ba, 210ab, 210bb, 210bc, 210ac, 210bc, 210ad, 210bd, 210cd; 310), welche in einem zweiten Raster angeordnet sind, annähernd die Quadratwurzel von zwei mal größer ist als der Abstand der mehreren elektrischen Kontakte, welche in dem ersten Raster angeordnet sind.

7. Mehrlagenleiterplatte nach Anspruch 4, wobei der Winkel zwischen dem ersten Raster und dem zweiten Raster annähernd 45 Grad beträgt.

8. Mehrlagenleiterplatte nach Anspruch 1, wobei die erste Untergruppe (207aa, 207ca, 207ea, 207bb, 207db, 207ac, 207cc, 207ec, 207bd, 207dd) der mehreren elektrischen Kontakte Bondpads umfasst.

9. Mehrlagenleiterplatte nach Anspruch 1, wobei die Durchkontaktierungen (210aa, 210ba, 210ab, 210bb, 210bc, 210ac, 210bc, 210ad, 210bd, 210cd; 310) an gegenüberliegenden Seiten benachbarter elektrischer Kontakte angeordnet sind, welche zu der zweiten Untergruppe (207ba, 207da, 207ab, 207cb, 207eb, 207bc, 207dc, 207ad, 207cd, 207ed) gehören.

10. Mehrlagenleiterplatte nach Anspruch 1, umfassend ein erstes Substrat, wobei die erste Lage (201) innerhalb einer ersten äußeren Fläche des ersten Substrats angeordnet ist, und wobei die mehreren Durchkontaktierungen (210aa, 210ba, 210ab, 210bb, 210bc, 210ac, 210bc, 210ad, 210bd und 210cd; 310) durch das erste Substrat gebohrt sind, zu einer zweiten anderen äußeren Fläche desselben, wobei die vierte Lage (204) innerhalb der zweiten anderen äußeren Fläche des ersten Substrats angeordnet ist.

11. Mehrlagenleiterplatte nach Anspruch 1, umfassend eine Kernlage, angeordnet zwischen der ersten und vierten Lage, wobei die Kernlage mehrere andere Lagen (202, 203) umfasst, welche im Wesentlichen parallel zu der ersten Lage (201) und der vierten Lage (204) sind, und wobei die mehreren anderen Lagen (202, 203) mehrere nicht leitende Bereiche (250) umfassen, welche die mehreren Durchkontaktierungen (210aa, 210ba, 210ab, 210bb, 210bc, 210ac, 210bc, 210ad, 210bd, 210cd; 310) umgeben.

12. Mehrlagenleiterplatte nach Anspruch 11, umfassend ein elektrisch leitendes Material (251), angeordnet um die mehreren nicht leitenden Bereiche (250), zum Reduzieren eines biplanaren Übersprechens zwischen der ersten Lage (201) und der vierten Lage (204).

13. Mehrlagenleiterplatte nach Anspruch 12, wobei die mehreren nicht leitenden Bereiche (250) auf eine derartige Weise angeordnet sind, dass Durchkontaktierungen, welche an benachbarten elektrischen Kontakten aus den mehreren elektrischen Kontakten (207aa, 207ca, 207ea, 207bb, 207db, 207ac, 207cc, 207ec, 207bd, 207dd, 207ba, 207da, 207ab, 207cb, 207eb, 207bc, 207dc, 207ad, 207cd, 207ed) gebildet sind, anders sind als unterstützt auf Grund von Überlappen zwischen benachbarten nicht leitenden Bereichen (250).

14. Mehrlagenleiterplatte nach Anspruch 13, wobei jeder der mehreren nicht leitenden Bereiche (250) frei ist von jeglichem anderen elektrischen Kontakt, außer einer Durchkontaktierung (210aa, 210ba, 210ab, 210bb, 210bc, 210ac, 210bc, 210ad, 210bd, 21 0cd; 310), welche darin angeordnet ist, sobald die Mehrlagenleiterplatte gebildet ist.

15. Mehrlagenleiterplatte nach Anspruch 1, wobei jede Durchkontaktierung (210aa, 210ba, 210ab, 210bb, 210bc, 210ac, 210bc, 210ad, 210bd, 210cd; 310) wenigstens zwei elektrischen Kontakten benachbart ist.

16. Verfahren zum Herstellen einer Mehrlagenleiterplatte, umfassend: Vorsehen einer ersten Lage (201); Vorsehen einer vierten Lage (204), im Wesentlichen parallel zu der ersten Lage (201); Anordnen mehrerer elektrischer Kontakte (207aa, 207ca, 207ea, 207bb, 207db, 207ac, 207cc, 207ec, 207bd, 207dd, 207ba, 207da, 207ab, 207cb, 207eb, 207bc, 207dc, 207ad, 207cd, 207ed; 311) in einem ersten Raster innerhalb der ersten Lage, wobei die mehreren elektrischen Kontakte in einer ersten Untergruppe (207aa, 207ca, 207ea, 207bb, 207db, 207ac, 207cc, 207ec, 207bd, 207dd) und einer zweiten Untergruppe (207ba, 207da, 207ab, 207cb, 207eb, 207bc, 207dc, 207ad, 207cd, 207ed) angeordnet sind; Routen der ersten Untergruppe (207aa, 207ca, 207ea, 207bb, 207db, 207ac, 207cc, 207ec, 207bd, 207dd) elektrischer Kontakte innerhalb der ersten Lage (201); Ausbilden von Durchkontaktierungen (210aa, 210ba, 210ab, 210bb, 210bc, 210ac, 210bc, 210ad, 210bd, 210cd; 310) zwischen der ersten Lage (201) und der vierten Lage (204), jede Durchkontaktierung benachbart wenigstens einem der zweiten Untergruppe (207ba, 207da, 207ab, 207cb, 207eb, 207bc, 207dc, 207ad, 207cd, 207ed) der mehreren elektrischen Kontakte, und jede Durchkontaktierung beabstandet von anderen Durchkontaktierungen um wenigstens 1,2 mal eine Mindestbeabstandung zwischen elektrischen Kontakten der ersten Untergruppe (207aa, 207ca, 207ea, 207bb, 207db, 207ac, 207cc, 207ec, 207bd, 207dd) und der zweiten Untergruppe (207ba, 207da, 207ab, 207cb, 207eb, 207bc, 207dc, 207ad, 207cd, 207ed); und Routen der zweiten Untergruppe (207ba, 207da, 207ab, 207cb, 207eb, 207bc, 207dc, 207ad, 207cd, 207ed) der mehreren elektrischen Kontakte innerhalb der vierten Lage (204).

17. Verfahren nach Anspruch 16, wobei der Abstand zwischen benachbarten Durchkontaktierungen annähernd eine Quadratwurzel von zwei mal den Abstand der mehreren elektrischen Kontakte (207aa, 207ca, 207ea, 207bb, 207db, 207ac, 207cc, 207ec, 207bd, 207dd, 207ba, 207da, 207ab, 207cb, 207eb, 207bc, 207dc, 207ad, 207cd, 207ed; 311) beträgt.

18. Verfahren nach Anspruch 16, umfassend: Vorsehen einer ersten Gruppe mehrerer elektrischer Bahnen, angeordnet innerhalb der ersten Lage (201), zum Routen der ersten Untergruppe (207aa, 207ca, 207ea, 207bb, 207db, 207ac, 207cc, 207ec, 207bd, 207dd) elektrischer Kontakte; und Vorsehen einer zweiten Gruppe mehrerer elektrischer Bahnen, angeordnet innerhalb der vierten Lage, zum Routen der zweiten Untergruppe (207ba, 207da, 207ab, 207cb, 207eb, 207bc, 207dc, 207ad, 207cd, 207ed) elektrischer Kontakte, wobei eine Anzahl an Elementen innerhalb der zweiten Gruppe mehrerer sich innerhalb von 50 % einer Anzahl an Elementen der ersten Gruppe mehrerer befindet.

19. Verfahren nach Anspruch 18, wobei eine Anzahl an Elementen innerhalb der zweiten Gruppe mehrerer sich innerhalb von 10 % einer Anzahl an Elementen der ersten Gruppe mehrerer befindet.

20. Verfahren nach Anspruch 16, wobei der Winkel annähernd 45 Grad beträgt.

21. Verfahren nach Anspruch 16, umfassend Vorsehen einer Kernlage zwischen der ersten Lage (201) und der vierten Lage (204), wobei die Kernlage mehrere andere Lagen (202, 203) umfasst, welche im Wesentlichen parallel zu der ersten Lage (201) und der vierten Lage (204) sind, wobei die mehreren anderen Lagen (202, 203) mehrere nicht leitende Bereiche (250) umfassen, welche die mehreren Durchkontaktierungen (210aa, 210ba, 210ab, 210bb, 210bc, 210ac, 210bc, 210ad, 210bd, 210cd; 310) umgeben.

22. Verfahren nach Anspruch 21, umfassend Vorsehen eines elektrisch leitenden Materials (251), angeordnet um die mehreren nicht leitenden Bereiche (250), zum Reduzieren eines biplanaren Übersprechens zwischen der ersten Lage (201) und der vierten Lage (204).

23. Verfahren nach Anspruch 21, wobei die mehreren nicht leitenden Bereiche (250) auf eine derartige Weise angeordnet sind, dass Durchkontaktierungen (210aa, 210ba, 210ab, 210bb, 210bc, 210ac, 210bc, 210ad, 210bd, 210cd; 310), welche an benachbarten elektrischen Kontakten aus den mehreren elektrischen Kontakten gebildet sind, anders sind als unterstützt auf Grund eines Überlappens zwischen benachbarten nicht leitenden Bereichen.

24. Verfahren nach Anspruch 23, wobei jeder der mehreren nichtleitenden Bereiche (250) frei ist von jeglichem anderen elektrischen Kontakt, außer einer Durchkontaktierung (210aa, 210ba, 210ab, 210bb, 210bc, 210ac, 210bc, 210ad, 210bd, 210cd; 310), welche darin angeordnet wird, sobald die Mehrlagenleiterplatte gebildet wird.

**Revendications**

1. Carte de circuit multicouches comprenant : une première couche (201), une quatrième couche (204) substantiellement parallèle à la première couche (201) ; une pluralité de contacts électriques (207aa, 207ca, 207ea, 207bb, 207db, 207ac, 207cc, 207ec, 207bd, 207dd, 207ba, 207da, 207ab, 207cb, 207eb, 207bc,207dc,207ad, 207cd, 207ed ; 311) formés dans la première couche (201) de la carte de circuit multicouches et disposés selon un premier réseau ayant un premier sous-ensemble (207aa, 207ca, 207ea, 207bb, 207db, 207ac, 207cc, 207ec, 207bd, 207dd) de la pluralité de contacts électriques pour un routage dans la première couche (201), et un deuxième sous-ensemble (207ba, 207da, 207ab, 207cb, 207eb, 207bc, 207dc, 207ad, 207cd, 207ed) de la pluralité de contacts électriques pour un routage dans la quatrième couche (204) ; et une pluralité de vias (210aa, 210ba, 210ab,210bb, 210bc, 210ac, 210bc, 210ad, 210bd, 210cd, 310) formés entre la première couche (201) et la quatrième couche (204) et disposés chacun à côté d'au moins un élément du deuxième sous-ensemble (207ba, 207da, 207ab, 207cb, 207eb, 207bc, 207dc, 207ad, 207cd, 207ed) de la pluralité de contacts électriques, la pluralité de vias (210aa, 210ba, 210ab,210bb, 210bc, 210ac, 210bc, 210ad, 210bd et 210cd ; 310) ayant un espacement entre eux deux à deux plus grand qu'un espacement plus faible entre des contacts électriques adjacents de la pluralité de contacts électriques (207aa, 207ca, 207ea, 207bb, 207db, 207ac, 207cc, 207ec, 207bd, 207dd, 207ba, 207da, 207ab, 207cb, 207eb, 207bc, 207dc, 207ad, 207cd, 207ed ; 311).

2. Carte de circuit multicouches selon la revendication 1, dans laquelle la pluralité de vias (210aa, 210ba, 210ab, 210bb, 210bc, 210ac, 210bc, 210ad, 210bd, 210cd ; 310) a un espacement d'au moins 1,1 fois l'espacement du premier réseau.

3. Carte de circuit multicouches selon la revendication 2, dans laquelle des contacts électriques parmi la pluralité de contacts électriques dans le premier réseau alternent entre le premier sous-ensemble de contacts électriques (207aa, 207ca, 207ea, 207bb, 207db, 207ac, 207cc, 207ec, 207bd, 207dd) et le deuxième sous-ensemble de contacts électriques (207ba, 207da, 207ab, 207cb, 207eb, 207bc, 207dc, 207ad, 207cd, 207ed).

4. Carte de circuit multicouches selon la revendication 1, dans laquelle le premier réseau comprend un réseau cartésien comprenant des colonnes et des lignes, dans lequel chaque ligne et chaque colonne comprennent des contacts électriques alternant entre le premier sous-ensemble (207aa, 207ca, 207ea, 207bb, 207db, 207ac, 207cc, 207ec, 207bd, 207dd) et le deuxième sous-ensemble (207ba, 207da, 207ab, 207cb, 207eb, 207bc, 207dc, 207ad, 207cd, 207ed), la pluralité de vias (210aa, 210ba, 210ab, 210bb, 210bc, 210ac, 210bc, 210ad, 210bd, 210cd ; 310) disposés selon un deuxième réseau comprenant des colonnes et des lignes ayant substantiellement un deuxième pas entre des vias adjacents, dans lequel les contacts électriques du premier sous-ensemble (207aa, 207ca, 207ea, 207bb, 207db, 207ac, 207cc, 207ec, 207bd, 207dd) sont routés dans la première couche (201) à l'aide d'une parmi une pluralité de premières traces électriques et les contacts électriques pour le deuxième sous-ensemble (207ba, 207da, 207ab, 207cb, 207eb, 207bc, 207dc, 207ad, 207cd, 207ed) sont routés dans la quatrième couche (204) à l'aide d'une parmi une pluralité de deuxièmes traces électriques.

5. Carte de circuit multicouches selon la revendication 4, dans laquelle le pas des vias (210aa, 210ba, 210ab, 210bb, 210bc, 210ac, 210bc, 210ad, 210bd et 210cd, 310) disposés selon un deuxième réseau est au moins 1,1 fois plus grand que le pas des contacts électriques disposés selon le premier réseau.

6. Carte de circuit multicouches selon la revendication 5, dans laquelle le pas des vias (210aa, 210ba, 210ab, 210bb, 210bc, 210ac, 210bc, 210ad, 210bd, 210cd ; 310) disposés selon un deuxième réseau est approximativement racine de deux fois plus grand que le pas de la pluralité de contacts électriques disposés selon le premier réseau.

7. Carte de circuit multicouches selon la revendication 4, dans laquelle l'angle entre le premier réseau et le deuxième réseau est d'approximativement 45 degrés.

**8.** Carte de circuit multicouches selon la revendication 1, dans laquelle le premier sous-ensemble (207aa, 207ca, 207ea, 207bb, 207db, 207ac, 207cc, 207ec, 207bd, 207dd) de la pluralité de contacts électriques comprend des plots de connexion.

**9.** Carte de circuit multicouches selon la revendication 1, dans laquelle les vias (210aa, 210ba, 210ab, 210bb, 210bc, 210ac, 210bc, 210ad, 210bd ,210cd; 310) sont disposés à des côtés opposés des contacts électriques adjacents appartenant au deuxième sous-ensemble (207ba, 207da, 207ab, 207cb, 207eb, 207bc, 207dc, 207ad, 207cd,207ed).

**10.** Carte de circuit multicouches selon la revendication 1, comprenant un premier substrat sur lequel est disposée la première couche (201) sur une première surface extérieure du premier substrat, et à travers lequel est percée une pluralité de vias (210aa, 210ba, 210ab,210bb, 210bc, 210ac, 210bc, 210ad, 210bd et 210cd ; 310) vers une deuxième surface extérieure sur laquelle est disposée la quatrième couche (204) sur la deuxième surface extérieure du premier substrat.

**11.** Carte de circuit multicouches selon la revendication 1, comprenant un noyau central disposé entre la première et la quatrième couches, dans laquelle le noyau central comporte une pluralité d'autres couches (202, 203) qui sont substantiellement parallèles à la première couche (201) et à la quatrième couche (203), et la pluralité d'autres couches (202, 203) comprenant une pluralité de zones conductrices (250) qui entourent la pluralité de vias (210aa, 210ba, 210ab, 210bb, 210bc, 210ac, 210bc, 210ad, 210bd et 210cd ; 310).

**12.** Carte de circuit multicouches selon la revendication 11, comprenant un matériau conducteur électrique (251), disposé autour de la pluralité de zones non conductrices (250) pour réduire une diaphonie biplanaire entre la première couche (201) et la quatrième couche (204).

**13.** Carte de circuit multicouches selon la revendication 12,dans laquelle la pluralité de zones non conductrices (250) est disposée de telle manière que les vias formés sur des contacts électriques adjacents à partir de la pluralité de contacts électriques (207aa, 207ca, 207ea, 207bb, 207db, 207ac, 207cc, 207ec, 207bd, 207dd, 207ba, 207da, 207ab, 207cb, 207eb, 207bc, 207dc, 207ad, 207cd, 207ed) sont autres que ceux supportés à cause de la superposition de zones adjacentes non conductrices (250).

**14.** Carte de circuit multicouches selon la revendication 13, dans laquelle chacune de la pluralité des zones non conductrices (250) est exempte de tout autre contact électrique qu'un via (210aa, 210ba, 210ab, 210bb, 210bc, 210ac, 210bc, 210ad, 210bd, 210cd ; 310) disposé dans celles-ci une fois que la carte de circuit multicouches est formée.

**15.** Carte de circuit multicouches selon la revendication 1, dans laquelle chaque via (210aa, 210ba, 210ab, 210bb, 210bc, 210ac, 210bc, 210ad, 210bd, 210cd ; 310) est adjacent à au moins deux contacts électriques.

**16.** Procédé de fabrication d'une carte de circuit multicouches comprenant : la mise en place d'une première couche (201) ; la mise en place d'une quatrième couche (204) substantiellement parallèle à la première couche (201), la mise en place d'une pluralité de contacts électriques (207aa, 207ca, 207ea, 207bb, 207db, 207ac, 207cc, 207ec, 207bd, 207dd, 207ba, 207da, 207ab, 207cb, 207eb, 207bc, 207dc, 207ad, 207cd, 207ed; 311) disposés selon un premier réseau dans la première couche, la pluralité de contacts électriques étant disposés selon un premier sous-ensemble (207aa, 207ca, 207ea, 207bb, 207db, 207ac, 207cc, 207ec, 207bd, 207dd) et un deuxième sous-ensemble (207ba, 207da, 207ab, 207cb, 207eb, 207bc, 207dc, 207ad, 207cd, 207ed) ; le routage du premier sous-ensemble (207aa, 207ca, 207ea, 207bb, 207db, 207ac, 207cc, 207ec, 207bd, 207dd) de contacts électriques dans la première couche (201) ; la formation de vias (210aa, 210ba, 210ab,210bb, 210bc, 210ac, 210bc, 210ad, 210bd, 210cd ; 310) entre la première couche (201) et la quatrième couche (204), chaque via étant adjacent à un élément au moins du deuxième sous-ensemble (207ba, 207da, 207ab, 207cb, 207eb, 207bc, 207dc, 207ad, 207cd, 207ed) de la pluralité de contacts électriques, et chaque via ayant un espacement par rapport aux autres vias d'au moins 1,2 fois l'espacement minimum entre les contacts électriques du premier sous-ensemble (207aa, 207ca, 207ea, 207bb, 207db, 207ac, 207cc, 207ec, 207bd, 207dd) et du deuxième sous-ensemble (207ba, 207da, 207ab, 207cb, 207eb, 207bc, 207dc, 207ad, 207cd, 207ed) ; et le routage du deuxième sous-ensemble (207ba, 207da, 207ab, 207cb, 207eb, 207bc, 207dc, 207ad, 207cd, 207ed) de la pluralité de contacts électriques dans la quatrième couche (204).

**17.** Procédé selon la revendication 16, dans lequel le pas entre des vias adjacents est approximativement racine de deux fois plus grand que le pas de la pluralité de contacts électriques (207aa, 207ca, 207ea, 207bb, 207db, 207ac, 207cc, 207ec, 207bd, 207dd, 207ba, 207da, 207ab, 207cb, 207eb, 207bc, 207dc, 207ad, 207cd, 207ed ; 311).

**18.** Procédé selon la revendication 16, comprenant : la mise en place d'une première pluralité de traces électriques disposées dans la première couche (201) pour le routage du premier sous-ensemble (207aa, 207ca, 207ea, 207bb, 207db, 207ac, 207cc, 207ec, 207bd, 207dd) de contacts électriques ; et la mise en place d'une deuxième pluralité de traces électriques disposées dans la quatrième couche pour le routage du deuxième sous-ensemble (207ba, 207da, 207ab, 207cb, 207eb, 207bc, 207dc, 207ad, 207cd, 207ed) de contacts électriques, dans lequel un nombre d'éléments de la deuxième pluralité est inférieur à 50% d'un nombre d'éléments de la première pluralité.

**19.** Procédé selon la revendication 18, dans lequel le nombre d'éléments dans la deuxième pluralité est inférieur à 10% d'un nombre d'éléments de la première pluralité.

**20.** Procédé selon la revendication 16, dans lequel l'angle est de 45 degrés environ.

**21.** Procédé selon la revendication 16, proposant un noyau central disposé entre la première couche (201) et la quatrième couche (204), dans lequel le noyau central comporte une pluralité d'autres couches (202, 203) qui sont substantiellement parallèles à la première couche (201) et à la quatrième couche (204), la pluralité d'autres couches (202, 203) comprenant une pluralité de zones non conductrices (250) qui entourent la pluralité de vias (210aa, 210ba, 210ab, 210bb, 210bc, 210ac, 210bc, 210ad, 210bd et 210cd ; 310).

**22.** Procédé selon la revendication 21, comprenant la mise en place d'un matériau conducteur électrique (251) disposé autour de la pluralité de zones non conductrices (250) pour réduire une diaphonie biplanaire entre la première couche (201) et la quatrième couche (204).

**23.** Procédé selon la revendication 21, dans lequel la pluralité de zones non conductrices (250) est disposée de telle manière que les vias (210aa, 210ba, 210ab, 210bb, 210bc, 210ac, 210bc, 210ad, 210bd, 210cd ; 310) formés sur des contacts électriques adjacents à partir de la pluralité de contacts électriques sont autres que ceux supportés à cause d'une superposition de zones adjacentes non conductrices.

**24.** Procédé selon la revendication 23, dans lequel chacune parmi la pluralité de zones non conductrices (250) est exempte de tout autre contact électrique autre que les vias (210aa, 210ba, 210ab, 210bb, 210bc, 210ac, 210bc, 210ad, 210bd, 210cd ; 310) disposés dans celles-ci une fois que la carte de circuit multicouches est formée.

**100**

**101a** **111** **101** **102**

**103**

**102a** **103a** **113** **112** **104**

# FIG. 1A
## PRIOR ART

**105** **106** **105** **106** **105**

**108** ( P ) ( G ) ( P ) ( G ) ( P )

( S ) ( S ) ( S ) ( S ) ( S )

**107**

**109** ( S ) ( S ) ( S ) ( S ) ( S )

**107**

( S ) ( S ) ( S ) ( S ) ( S )

( S ) ( S ) ( S ) ( S ) ( S )

# FIG. 1B
## PRIOR ART

FIG. 1C
PRIOR ART

FIG. 1D
PRIOR ART

FIG. 2A

FIG. 2B

FIG. 2C

FIG. 2D

319a
315
316
319b
317
318
319c
315
316
319d

**FIG. 3A**

350

301
302
303
304
305
306
307
308

L1
L2
L3
L4
L5
L6
L7
L8

**FIG. 3B**

300

321
322
323
324
325
326
327
328
329
330

L1
L2
L3
L4
L5
L6
L7
L8
L9
L10

**FIG. 3C**

FIG. 3D

310

311

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6150729 A